**Europäisches Patentamt**

**European Patent Office**

**Office européen des brevets**

(11) Publication number : **0 481 698 A2**

# (12) EUROPEAN PATENT APPLICATION

(21) Application number : **91309411.6**

(22) Date of filing : **14.10.91**

(51) Int. Cl.⁵ : **H03K 19/20**, H03K 19/173

(30) Priority : **15.10.90 JP 273510/90**

(43) Date of publication of application :
**22.04.92 Bulletin 92/17**

(84) Designated Contracting States :
**DE FR GB**

(71) Applicant : **International Business Machines
Corporation
Old Orchard Road
Armonk, N.Y. 10504 (US)**

(72) Inventor : **Nishino, Kiyoshi
1-9-19 Tsuruma, Yamato-shi
Kanagawa-ken (JP)**
Inventor : **Tomonaga, Yasumasa
6-4-4 Sagamiohno, Sagamihara-shi
Kanagawa-ken (JP)**

(74) Representative : **Killgren, Neil Arthur
IBM United Kingdom Limited Intellectual
Property Department Hursley Park
Winchester Hampshire SO21 2JN (GB)**

(54) **Tri-state circuit.**

(57)   There is provided a tri-state circuit comprising first and second transistors connected in series between two source voltage levels, an output line being taken from the point of connection of the transistors and a resistance connected between either of said source voltage levels and the output line, the first transistor being turned on in response to an input signal applied to a first input line, an output signal appearing on said output line in response to said input signal, both said transistors being turned off in response to an input signal applied to a second input line, characterised by means for turning on the one of said transistors connected to the source voltage level to which the resistance is connected for a predetermined time in response to an input signal applied to said second input line before said first and second transistors are turned off, thereby accelerating charging or discharging of said output line. An integrated circuit including such a tri-state circuit is also provided.

FIG. 1

EP 0 481 698 A2

The invention relates to a tri-state circuit having low power consumption.

FIG.3 is a diagram showing a typical conventional pull-up type tri-state circuit. In the figure, the input of an inverter 3 is connected to a data line 1 and its output is connected to one input of an OR gate 5 as well as to one input of an AND gate 6. The input of an inverter 4 is connected to an enable (EN) line 2 as well as the other input of the OR gate 5 and its output is connected to the other input of the AND gate 6. The gate of a P-channel enhancement-type MOS FET (thereafter, called P-type FET) 7 is connected to an output of the OR gate 5, a drain terminal of the P-type FET 7 is connected so that a first source voltage Vc is applied, and its source terminal is connected to a drain terminal of a N-channel enhancement-type MOSFET (thereafter, called N-type FET) 8. A gate terminal of the N-type FET 8 is connected to an output of the AND gate 6 and its source terminal is connected to a second source voltage, that is, reference potential (ground potential). The point of connection of the source terminal of the P-type FET 7 with the drain terminal of the N-type FET 8 is connected to output line 10. One end of a pull-up resistance 9 is connected to the first source voltage Vc and the other end of the resistance 9 is connected to the output line 10. To the output line 10, an input circuit 11 to a next-stage CMOS circuit is connected. In the CMOS circuit, input to the next-stage CMOS circuit becomes unsteady if the output line 10 is in a floating state. This is the reason why the pull-up resistance 9 is provided.

In the following, the operation of the conventional tri-state circuit shown in FIG.3 is described.

If an EN signal at logical 1 level is provided to the enable line 2, the output signal from the OR gate 5 is always logical 1 level and thus the MOSFET 7 is always switched off; on the other hand, an output signal from the AND gate 6 is always logical 0 level and thus the MOSFET 8 is always switched off. From the above, when an EN signal is at logical 1 level, both FET 7 and FET 8 are always switched off, regardless of a value of a data signal provided to the data line 1. That is, when an EN signal is at logical 1 level, the output line 10 is put in a high impedance state.

Also, when the EN signal at logical 0 level is supplied to the enable line 2, data line 1 at logical level causes the output signal from the OR gate 5 to become logical 0 level and the output signal from the AND gate 6 to become logical 0 level. Accordingly, the P-type FET 7 is turned on and, on the other hand, the N-type FET 8 is turned off. Thus, this causes the output signals to become the logical 1 level.

Also, if the EN signal at logical 0 level is supplied to the enable line 2, the data line 1 at logical 0 level causes an output signal from the OR gate 5 to become logical 1 level and an output signal from the AND gate 6 to become logical 1 level. Accordingly, the P-type FET 7 is turned off and, on the other hand, the. N-type FET 8 is turned on. Thus, this causes the output signals to become logical 0 level.

As is obvious from the above, the integrated circuit has three states (1 level state, 0 level state, and high impedance state) in response to the enable signal.

In the above conventional circuit, when a data signal at logical 0 level is supplied to the data line 1, an output signal at logical 0 level is provided to the output line 10. In a state where a data signal at logical 0 level has been given to the data line 1, if an EN signal applied to the enable line 2 changes from logical 0 level to logical 1 level, the output circuit becomes a high-impedance state and thereby floating capacitance in the output line 10 gradually charges up, through the pull-up resistance 9, to a source voltage level. In such a state, an output signal rises to the source voltage level from the level 0, for example, in 500-600 ns to 5-6 s in accordance with the time constant determined by the pull-up resistance 9 and the above floating capacitance. Since the output signal does not rise abruptly in such a state, all the while the length of time for which an input level in the next-stage CMOS circuit which receives the output signal indicates an intermediate value is increased, a through current continues to flow in the next-stage CMOS circuit and thereby power is consumed. In such a case, it is a problem that in particular, the more a data signal involves many logical 0 level signals, the more the above through current increases and power consumption increases in proportion to the increase of the through current.

The present invention enables to be provided a tri-state circuit comprising first and second transistors connected in series between two source voltage levels, an output line being taken from the point of connection of the transistors and a resistance connected between either of said source voltage levels and the output line, the first transistor being turned on in response to an input signal applied to a first input line, an output signal appearing on said output line in response to said input signal, both said transistors being turned off in response to an input signal applied to a second input line, characterised by means for turning on the one of said transistors connected to the source voltage level to which the resistance is connected for a predetermined time in response to an input signal applied to said second input line before said first and second transistors are turned off, thereby accelerating charging or discharging of said output line.

The invention enables the above problem to be solved by enabling a tri-state circuit of low power consumption to be provided.

The invention further provides an integrated circuit including the above tri-state circuit.

In the invention, before both a first and a second transistors are turned off in response to the other input signal, either said first or said second transistor to which an output line is connected through a resistance is turned on in response to said other input signal, during a predetermined period of time to abruptly charge or discharge the output line by means for accelerating charge or discharge.

An embodiment of the invention will now be described, by way of example only, with reference to the accompanying drawing, wherein:

FIG.1 is a diagram showing a construction of an integrated circuit of an embodiment of the invention.

FIG.2 shows waveforms in respective sections of FIG.1.

FIG.3 is a diagram showing a construction of a conventional integrated circuit.

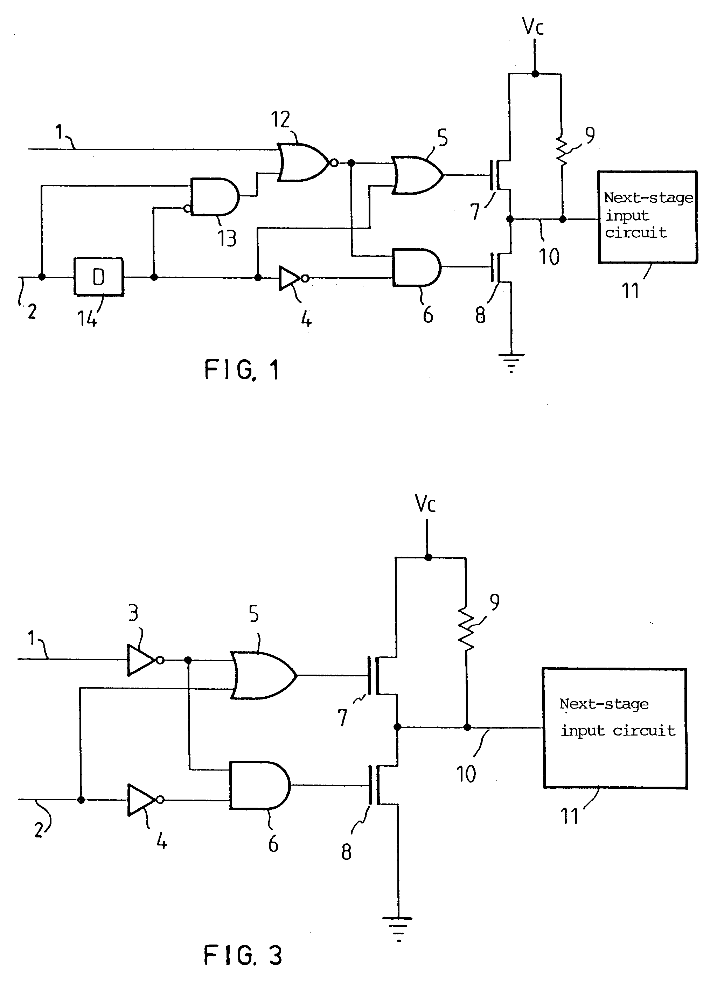

FIG.1 is a diagram showing a construction of an integrated circuit having a pull-up type tri-state circuit according to an embodiment of the invention. In the figure, one input of a NOR gate 12 is connected to a data line 1 and the other input of the NOR gate 12 is connected to the output of an AND gate 13. Also, one input of the AND gate 13 is connected to an enable line 2 and the other inverted input is connected, through a delay circuit 14, to the enable line 2. Likewise, the input of an inverter 4 is connected, through the delay circuit 14, to the enable line 2.

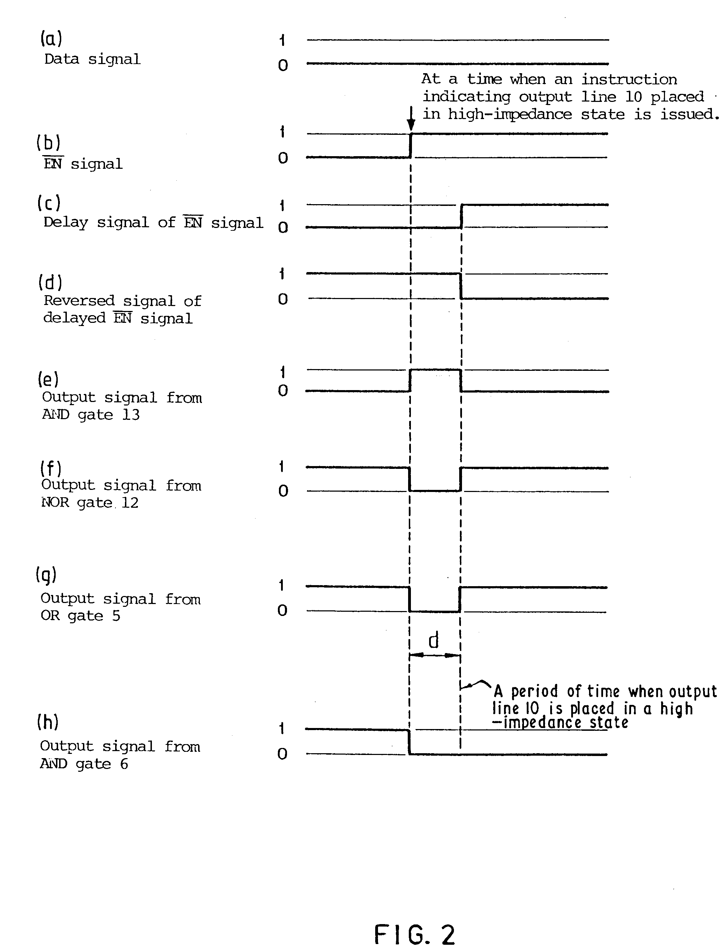

The operation of the circuit of FIG.1 is described by using the waveforms shown in FIG.2 in respective sections of the circuit shown in FIG.1, as follows.

First, consideration is made of a case where a data signal of logical 0 level (shown by a solid line (a) in FIG.2) is applied to the data line 1 to which one input of the NOR gate 12 is connected and a signal which transits from logical 0 level to logical 1 level (shown by (b) in FIG.2) is applied to the EN line 2 to which the other input of the NOR gate 12 is indirectly connected. A point at which an EN signal makes the transition from logical 0 level to logical 1 level indicates a time when an instruction indicating ligh impedance state in the output line 10 is issued. When the above input signals are applied, an EN signal applied to the enable line 2 is delayed by a predetermined period of time, for example, several nanoseconds (ns), by means of a delay circuit 14 and a delayed signal (shown by (c) in FIG.2) is inputted to one of the inputs of the OR gate 5 as well as to the inverter 4 to produce an inverted signal (shown by (d) in FIG.2). AND gate 13 performs the AND operation of the above EN signal ((b) in FIG.2) and an inverted signal ((d) in FIG.2) to a delayed EN signal ((c) in FIG.2) to produce an output signal ((e) in FIG.2). Also, a NOR gate 12 performs the OR operation of the data signal ((a) in FIG.2) and the output signal ((e) in FIG.2) from the AND gate 13 to produce an inverted output signal ((f) in FIG.2). The output signal is applied to the one input of the OR gate 5. To the other input of the OR gate 5, the inverted signal ((d) in FIG.2) to the delayed EN signal is applied. The OR gate 5 performs the OR operation of both input signals to produce an output signal shown by (g) in FIG.2. The output signal is applied to a P-type FET 7 to turn the P-type FET 7 on during a period of time d and then to turn it off. On the other hand, AND gate 6 performs the AND operation of the output signal from the NOR gate 12 and the output signal from the inverter 4 to produce an output signal ((h) in FIG.2) applied to a N-type FET 8. Since the output signal is at a logical 0 level, the N-type FET 8 is turned off.

Thus, before both the P-type FET 7 and the N-type FET 8 are turned off, only the P-type FET 7 is turned on, the output line is abruptly charged to a source voltage Vc level, and then both the P-type FET 7 and the N-type FET 8 are turned off to place the output line 10 in a high-impedance state.

By performing the above operation, the through current is be completely removed and thus power consumption is decreased.

In the above embodiment, an integrated circuit provided with a pull-up type tri-state circuit has been described. However, an integrated circuit provided with a pull-down type tri-states circuit is the same as the integrated circuit of the embodiment except that the integrated circuit having the pull-down type tri-states circuit places an output line in a high-impedance state after the output line has been abruptly discharged through a pull-down resistance.

According to the invention, as shown above, since when an enable signal EN is switched from a logical 0 level to a logical 1 level, before both a P-type FET and a N-type FET are turned off, and the P-type transistor the output line of which has been pulled up is turned on during a predetermined period of time, the output line is abruptly charged to a source voltage level, and then both the P-type FET and the N-type FET are turned off to place the output line in a high-impedance state and completely remove the above through current, power consumption can be decreased, the amount of heat generated is small even though the number of gates is increased, and thus a plastic-packaged, economical integrated circuit can be provided.

There has been described an integrated circuit including a tri-states circuit wherein an output line being taken out of a point of connection of a first and a second transistors connected in series between a first and a second source voltage levels, one of said transistors being turned on in response to an input signal on one input line connected to the control terminals of said first and said second transistors, an output signal appearing, in response to said input signal, on said output line, both said first and said second transistors being turned off in response to an input signal on the other input line connected to the control terminals of said first and said second transistors and a resistance across either said first or said second source voltage level and said output line; in which means for accelerating, through said resistance, charge or discharge of said output line in response to an input signal provided to said other input line and means for turning on one of said transistors which is connected to said output line, to which the source voltage level is applied, connected through said resistance only for a predetermined time in response to an input signal on said other input line are provided, before both said first and said second transistors are turned off in response to an input signal applied to said other input line.

**Claims**

1. A tri-state circuit comprising first and second transistors connected in series between two source voltage levels, an output line being taken from the point of connection of the transistors and a resistance connected between either of said source voltage levels and the output line, the first transistor being turned on in response to an input signal applied to a first input line, an output signal appearing on said output line in response to said input signal, both said transistors being turned off in response to an input signal applied to a second input line, characterised by means for turning on the one of said transistors connected to the source voltage level to which the resistance is connected for a predetermined time in response to an input signal applied to said second input line before said first and second transistors are turned off, thereby accelerating charging or discharging of said output line.

2. A tri-state circuit as claimed in Claim 1 wherein said first and said second transistors are complementary MOSFETs.

3. A tri-state circuit as claimed in Claim 1 or Claim 2 wherein an input signal on said one input line is a data signal.

4. A tri-state circuit as claimed in any preceding claim wherein an input signal on said second input line is a state control signal consisting of an output inhibiting signal which prevents an output signal from occurring on said output line.

5. A tri-state circuit as claimed in any preceding claim wherein said predetermined time is determined based on a delay time in delay means.

6. An integrated circuit including a tri-state circuit as claimed in any preceding claim.

7. An integrated circuit including a tri-states circuit wherein an output line being taken out of a point of connection of a first and a second transistors connected in series between a first and a second source voltage levels, one of said transistors being turned on in response to an input signal on one input line connected to the control terminals of said first and said second transistors, an output signal appearing, in response to said input signal, on said output line, both said first and said second transistors being turned off in response to an input signal on the other input line connected to the control terminals of said first and said second transistors and a resistance across either said first or said second source voltage level and said output line, comprising;

means for accelerating, through said resistance, charge or discharge of said output line in response to an input signal on said other input line and;

means for turning on one of said transistors which is connected to said output line, to which the source voltage level is applied, connected through said resistance, only for a predetermined time in response to an input signal to said other input line before both said first and said second transistors are turned off in response to an input signal applied to said other input line.

FIG. 1

FIG. 3

5

(a)
Data signal

At a time when an instruction
indicating output line 10 placed
in high-impedance state is issued.

(b)
$\overline{EN}$ signal

(c)
Delay signal of $\overline{EN}$ signal

(d)
Reversed signal of
delayed $\overline{EN}$ signal

(e)
Output signal from
AND gate 13

(f)
Output signal from
NOR gate 12

(g)
Output signal from
OR gate 5

d

A period of time when output
line 10 is placed in a high
−impedance state

(h)
Output signal from
AND gate 6

FIG. 2